(19) Europäisches Patentamt / European Patent Office / Office européen des brevets

(11) **EP 2 479 792 A1**

(12) **DEMANDE DE BREVET EUROPEEN**

(43) Date de publication:
**25.07.2012 Bulletin 2012/30**

(51) Int Cl.:
*H01L 29/786* $^{(2006.01)}$     *H01L 21/265* $^{(2006.01)}$
*H01L 21/336* $^{(2006.01)}$     *H01L 29/66* $^{(2006.01)}$

(21) Numéro de dépôt: **12354004.9**

(22) Date de dépôt: **12.01.2012**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **24.01.2011 FR 1100200**

(71) Demandeur: **Commissariat à l'Énergie Atomique et aux Énergies Alternatives 75015 Paris (FR)**

(72) Inventeurs:
• **Grenouillet, Laurent 38140 Rives (FR)**
• **Vinet, Maud 38140 Rives (FR)**

(74) Mandataire: **Talbot, Alexandre et al Cabinet Hecké Europole, BP 1537 10, rue d'Arménie 38025 Grenoble Cedex 1 (FR)**

(54) **Dispositif à effet de champ muni d'une contre-électrode amincie et procédé de réalisation.**

(57)     Le dispositif à effet de champ comporte un substrat (1) de type semi-conducteur sur isolant muni successivement d'un substrat de support (2), d'une couche électriquement isolante (3) et d'un film en matériau semi-conducteur (4). Des première et seconde électrodes de source/drain sont formées dans la couche en matériau semi-conducteur (4). Un canal de conduction est formé dans la couche en matériau semi-conducteur (4) et séparant les première et seconde électrodes de source/drain. Une contre-électrode est formée dans le substrat de support (2) et faisant face aux première et seconde électrodes de source/drain et au canal de conduction. La contre-électrode est formée par une zone dopée du substrat de support (2) ayant une concentration en première impureté dopante décroissante depuis une interface entre la couche électriquement isolante (3) et le substrat de support (2).

Figure 2

EP 2 479 792 A1

## Description

## Domaine technique de l'invention

L'invention est relative à un dispositif à effet de champ formé sur un substrat de type semi-conducteur sur isolant avec une contre-électrode.

L'invention est également relative à un procédé de réalisation d'un tel dispositif à effet de champ.

## État de la technique

Avec la réduction continue de leurs dimensions, les dispositifs actifs des circuits intégrés, comme les transistors, se heurtent à des phénomènes physiques qui se traduisent par des effets parasites sur les caractéristiques électriques principales des dispositifs, par exemple l'effet canal court. Afin de remédier à un certain nombre de ces écueils, différentes solutions sont envisagées.

Les substrats sur lesquels les transistors sont intégrés ont été modifiés afin de réduire certains des phénomènes parasites des transistors. Ces substrats améliorés sont de type semi-conducteur sur isolant. Ils sont formés par une couche en matériau semi-conducteur séparée du substrat de support par un matériau diélectrique. Selon l'épaisseur de la couche en matériau semi-conducteur sur laquelle est intégré le transistor à effet de champ, le substrat est dit partiellement ou complètement déplété.

En utilisant successivement les substrats de type semi-conducteur sur isolant partiellement déplété puis complètement déplété, il a été possible de poursuivre la course à la miniaturisation et au perfectionnement continu des transistors.

Les substrats de type semi-conducteur sur isolant complètement déplété ont ensuite été modifiés en diminuant l'épaisseur de la couche en matériau diélectrique et en intégrant une couche dopée dans le substrat de support. Cette couche dopée est réalisée à proximité de la couche diélectrique afin de former un plan de masse. Ce plan de masse permet une meilleure maîtrise des effets parasites du transistor intégré sur la couche en matériau semi-conducteur, notamment l'effet canal court au moyen d'une meilleure commande de l'abaissement de la barrière induite par l'électrode de drain (DIBL). Utiliser un plan de masse permet également de modifier facilement les caractéristiques électriques du transistor, typiquement en faisant évoluer sa tension de seuil.

Cependant, l'utilisation d'un plan de masse requiert l'intégration d'étapes technologiques supplémentaires ce qui se traduit inévitablement par de nouvelles contraintes de fabrication.

Comme illustré dans le document US 5889306, le plan de masse est formé dans le substrat de support par implantation ionique à travers le film semi-conducteur sur isolant et la couche électriquement isolante. Le plan de masse est formé en début de procédé afin de faciliter la mise en oeuvre.

Cependant, avec ce type de schéma d'intégration associé à la diminution continue des dimensions du transistor, une dégradation des performances du transistor est observée en comparaison des résultats théoriques attendus. De même, ce type de procédé de mise en oeuvre devient difficile à mettre en place car l'étendue en profondeur des contre-électrodes est importante ce qui nécessite d'utiliser de nombreux moyens d'isolation spécifiques.

## Objet de l'invention

On constate qu'il existe un besoin de prévoir un transistor à effet de champ muni d'une contre-électrode qui présente un encombrement réduit.

On tend à assouvir ce besoin au moyen d'un dispositif qui comporte :

- un substrat de type semi-conducteur sur isolant muni successivement d'un substrat de support, d'une couche électriquement isolante et d'un film en matériau semi-conducteur,
- des première et seconde électrodes de source/drain formées dans la couche en matériau semi-conducteur,
- un canal de conduction formé dans la couche en matériau semi-conducteur et séparant les première et seconde électrodes de source/drain,
- une contre-électrode formée dans le substrat de support et faisant face aux première et seconde électrodes de source/drain et au canal de conduction, la contre-électrode est formée par une zone dopée du substrat de support ayant une concentration en première impureté dopante décroissante depuis une interface entre la couche électriquement isolante et le substrat de support.

On constate également qu'il existe un besoin de prévoir un procédé de réalisation d'un tel transistor qui soit facile à mettre en oeuvre et qui soit facilement co-intégrable avec les procédés de réalisation des circuits électroniques.

Le dispositif est réalisé selon un procédé comprenant les étapes suivantes :

- prévoir un substrat muni successivement d'un substrat de support avec un premier film en matériau semi-conducteur, une couche électriquement isolante, un second film en matériau semi-conducteur, une électrode de grille séparée du second film en matériau semi-conducteur par un diélectrique de grille,
- réaliser une implantation ionique d'une première impureté dopante avec un angle non nul par rapport à la surface du second film en matériau semi-conducteur de manière à former dans le premier film en matériau semi-conducteur une zone dopée d'un premier type de conductivité en face de l'électrode de grille, la concentration en première impureté dopante diminuant à partir de l'interface entre le premier film en matériau semi-conducteur et la couche électriquement isolante au fur et à mesure que l'on s'éloigne de la couche électriquement isolante.

**Description sommaire des dessins**

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- les figures 1 à 3 représentent, de manière schématique, en vue de coupe, différentes étapes de réalisation d'un dispositif,
- la figure 4 représente, le profil de concentration en première impureté dopante dans le substrat le long de l'axe z illustré à la figure 3 dans un mode particulier de mise en oeuvre,
- les figures 5 et 6 représentent, de manière schématique, en vue de coupe, deux modes de réalisation particuliers d'un dispositif à effet de champ,
- la figure 7 représente, deux profils de concentration issus de deux étapes d'implantation distinctes dans le substrat le long de l'axe z illustré à la figure 3 dans un mode particulier de mise en oeuvre,
- les figures 8 à 10, représentent, de manière schématique, en vue de coupe, une variante de réalisation d'un dispositif à effet de champ.

**Description de modes de réalisation préférentiels de l'invention**

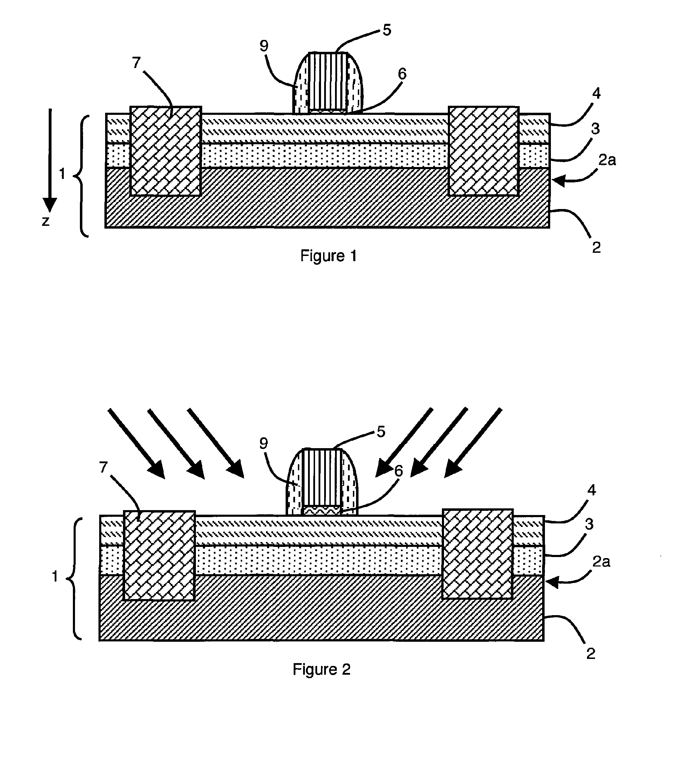

Comme cela est illustré à la figure 1, un substrat 1 de type semi-conducteur sur isolant comporte successivement un substrat de support 2, une couche électriquement isolante 3 et un film en matériau semi-conducteur 4. Le film en matériau semi-conducteur 4 est une couche dite active car elle est destinée à intégrer un ou plusieurs transistors à effet de champ ou d'autres dispositifs.

Le substrat de support 2 comporte un film 2a en matériau semi-conducteur qui est en contact avec la couche électriquement isolante 3. Selon les modes de réalisation, le substrat 2 peut être formé par un seul et même matériau semi-conducteur ou par une pluralité de films différents conducteurs électriquement ou non. De manière préférentielle, le substrat de support 2 est formé par un matériau semi-conducteur, par exemple du silicium.

De cette manière, le premier film semi-conducteur 2a du substrat de support 2 est séparé d'un second film semi-conducteur, le film 4, par la couche électriquement isolante 3.

Une électrode de grille 5 est formée sur le film en matériau semi-conducteur 4. L'électrode de grille 5 est séparée du film en matériau semi-conducteur 4 par un diélectrique de grille 6.

Le substrat 1 comporte alors successivement, le substrat de support 2, la couche électriquement isolante 3, le film en matériau semi-conducteur 4, le diélectrique de grille 6 et l'électrode de grille 5.

Dans un mode de réalisation particulier, un motif d'isolation 7 est formé pour définir la zone active du transistor. Le motif d'isolation 7 est formé autour de l'électrode de grille 5 dans le substrat 1 avec une partie pouvant s'étendre sous l'électrode de grille 5 afin d'autoriser une délimitation sure entre les zones de source et drain. Le motif d'isolation 7 s'enfonce dans le film semi-conducteur 4, la couche électriquement isolante 3 et le substrat de support 2. Le motif d'isolation 7 permet d'isoler électriquement le futur transistor d'autres composants adjacents et la future contre-électrode du reste du substrat 1.

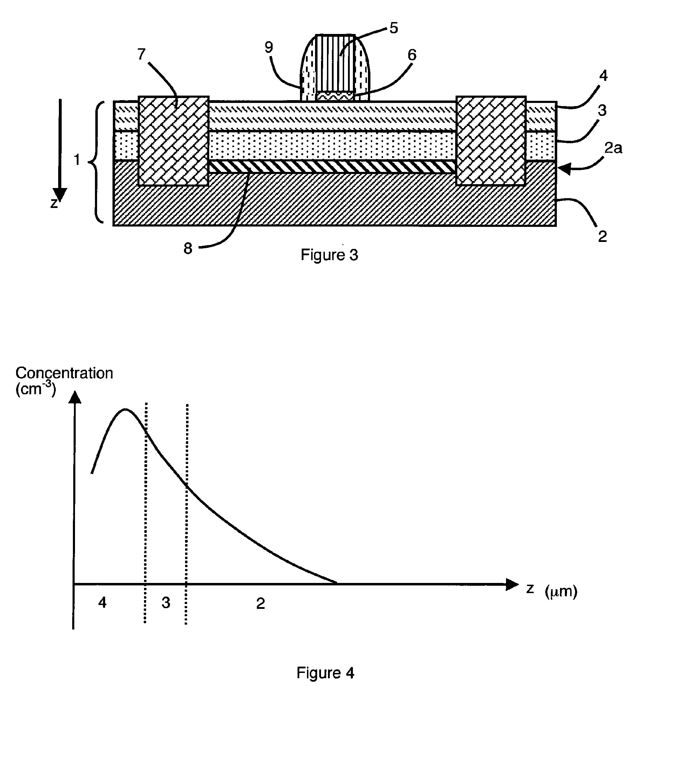

Comme cela est illustré aux figures 2 et 3, le substrat 1 est soumis à une étape d'implantation ionique tiltée d'une première impureté dopante. Cette implantation ionique permet de former une contre-électrode 8, par dopage d'une partie du premier film semi-conducteur 2a. La contre-électrode 8 est d'un premier type de conductivité et le type de conductivité est imposé par le type de la première impureté dopante. A titre d'exemple, si la première impureté dopante est de l'arsenic ou du phosphore, la contre-électrode 8 est de type N. Au contraire, si la première impureté dopante est du bore ou de l'indium, la contre-électrode est de type P.

La contre-électrode 8 agit de manière électrostatique sur les performances du transistor au moyen de la couche électriquement isolante 3. Comme cela est illustré à la figure 4, la contre-électrode 8 comporte une concentration décroissante en première impureté dopante le long de l'axe z au fur et à mesure que l'on s'éloigne de l'interface entre la couche électriquement isolante 3 et le premier film semi-conducteur 2a. La concentration en dopants sur la figure 3 est représentée avec une échelle logarithmique.

Ce profil particulier de dopage permet d'obtenir simultanément une contre-électrode ayant un faible encombrement en profondeur et un effet électrostatique important sur le transistor et donc sur ses performances électriques. L'encombrement en profondeur est défini dans une direction perpendiculaire à l'interface entre la couche électriquement isolante et le film semi-conducteur 4. La profondeur est dirigée selon l'axe z en s'éloignant de l'interface entre la couche électriquement isolante 3 et le substrat de support 2.

Ce profil particulier de dopage permet d'obtenir un effet électrostatique maximal car la zone la plus dopée (la concentration la plus forte en première impureté) est disposée au plus près du second film semi-conducteur 4 et donc du canal associé.

Ce profil permet également de réduire l'influence de la contre-électrode 8 sur les dispositifs adjacents car le dopage décroît avec l'enfoncement dans le substrat de support 2. Dans ces conditions, l'encombrement selon l'axe z est faible ce qui réduit l'influence de la contre-électrode 8 sur les éléments adjacents. Ce faible encombrement permet, entre autres, d'utiliser des motifs d'isolation 7 moins profonds entre les différents dispositifs utilisés et/ou de réduire les moyens d'isolations de la contre-électrode comme des caissons dopés de type opposé.

En comparaison, dans l'art antérieur, le profil de dopage de la contre-électrode est différent car il est réalisé dès le début du procédé de mise en oeuvre.

De manière classique, dans l'art antérieur, le maximum de dopant est placé à distance de l'interface entre la couche 3 et le film 2a de manière à avoir une quantité maximale de dopants dans le substrat de support et réduire fortement le dopage parasite dans le canal de conduction. Il y a donc une perte d'efficacité importante dans les contre-électrodes de l'art antérieur. Le profil de dopage n'est pas favorable à une bonne contre-électrode et peut être partiellement gommé au moyen des différents recuits thermiques du procédé de mise en oeuvre, mais cela se traduit par une augmentation du volume de la contre-électrode. Cependant, les différents recuits thermiques sont limités par les contraintes qui pèsent sur la diffusion des dopants depuis les électrodes de source/drain vers le canal.

La contre-électrode est formée par dopage du substrat à travers l'intégralité de la zone active découverte. Une implantation énergétique est réalisée pour conserver la pureté du canal de conduction ce qui conditionne en partie les performances du transistor. Une précaution est prise afin de ne pas rendre amorphe, ni détériorer le futur canal de conduction.

D'autre part, la contre-électrode n'est pas placée trop loin du dispositif et donc de l'interface entre le film semi-conducteur 2a et la couche électriquement isolante 3 pour avoir un effet électrostatique important. Ces deux conditions incitent donc à utiliser une énergie d'implantation élevée et à profiter des budgets thermiques à venir pour améliorer le profil de dopants dans la contre-électrode.

Pour obtenir un profil décroissant dans le substrat de support depuis l'interface entre la couche électriquement isolante 3 et le film semi-conducteur 2a, il est préférable de choisir l'énergie d'implantation de manière à avoir la concentration maximale en première impureté dopante dans la couche isolante 3 ou dans le second film semi-conducteur 4. La queue d'implantation réalise alors le dopage du premier film semi-conducteur 2a afin de former la contre-électrode 8 avec le profil voulu. L'énergie d'implantation est plus faible que dans l'art antérieur car on cherche une profondeur d'implantation plus faible, le canal étant déjà défini et protégé par la grille. Le pic d'implantation peut également être placé au plus près de l'interface entre la couche isolante 3 et le film semi-conducteur 2a.

L'étape d'implantation est réalisée après la formation de l'électrode de grille 5. L'électrode de grille 5 est utilisée comme un masque. Dans ces conditions, le canal de conduction n'a pas subi d'implantation parasite ce qui permet d'avoir un canal de conduction non intentionnellement dopé ou un canal dont le profil d'implantation est parfaitement maîtrisé. Cette position de l'étape d'implantation ionique permet de former un transistor avec une bonne conduction des porteurs dans le canal de conduction. Les conditions d'implantation sont choisies de manière à obtenir un dopage continu sous l'électrode de grille 5. Ainsi, bien que le canal de conduction soit protégé par l'électrode de grille 5, il est possible d'incorporer la première impureté dopante sous le canal de conduction dans le substrat de support 2.

L'étape d'implantation ionique est dite tiltée, elle présente un angle d'implantation non nul c'est-à-dire que l'implantation ionique est réalisée avec un décalage angulaire par rapport à la perpendiculaire à la surface du substrat 1, ici du second film semi-conducteur 4.

L'angle d'implantation est choisi de manière à former une zone dopée continue sous l'électrode de grille 5 dans le premier film semi-conducteur 2a et donc à la surface du substrat de support 2 sans doper le canal de conduction. L'angle d'implantation peut introduire quelques impuretés dopantes sous la grille 5 en fonction de l'angle d'implantation choisi. Cette implantation aura pour effet de réduire la taille du canal de conduction. L'homme du métier choisira l'angle d'implantation de manière à conserver une longueur de grille suffisante pour conserver l'effet transistor tout en assurant une bonne répartition des espèces dopantes sous le canal de conduction dans le substrat de support 2.

L'angle d'implantation est fonction de la longueur de la grille 5 en prenant en compte les éventuels espaceurs 8. L'angle d'implantation tient également compte de l'épaisseur du film semi-conducteur 4 sous la grille et de l'épaisseur de la couche électriquement isolante 3. La longueur physique de grille correspond à la distance qui sépare l'électrode de source et l'électrode de drain.

L'angle d'implantation doit être supérieur ou égal à la valeur obtenue avec la formule géométrique suivante : $\beta = \arctan\left(\dfrac{L/2}{T_4 + T_3}\right)$ avec

$L/2$, la demi-longueur de l'électrode de grille incluant, le cas échéant, les espaceurs latéraux présents durant l'implantation

$T_4 + T_3$, l'épaisseur totale de la couche électriquement isolante 3 et du film semi-conducteur 4 sous l'électrode de grille.

A titre d'exemple, un angle minimal d'implantation de 25,8° est utilisé pour une grille ayant une longueur de 30nm disposée sur un film semi-conducteur de 6nm d'épaisseur et sur une couche électriquement isolante 3 de 25nm d'épaisseur. Pour une grille ayant une longueur de 46nm disposée sur un film semi-conducteur de 6nm d'épaisseur et sur une couche électriquement isolante 3 de 10nm d'épaisseur, l'angle minimal d'implantation est égal à 55,2°.

L'énergie d'implantation est choisie de manière à ce qu'une quantité suffisante de première impureté dopante atteigne le premier film semi-conducteur 2a. L'énergie d'implantation est donc fonction de la distance à parcourir avant d'atteindre l'interface entre la couche électriquement isolante 3 et le premier film semi-conducteur 2a. Ainsi, plus l'épaisseur de la couche en matériau semi-conducteur 4 et/ou l'épaisseur de couche électriquement isolante 3 sont importantes et plus l'énergie d'implantation est élevée.

L'énergie d'implantation est choisie pour incorporer la première impureté dopante dans le premier film semi-conducteur 2a du substrat de support 2 de manière à avoir un profil de concentration décroissant au fur et à mesure que l'on s'enfonce dans le substrat de support 2, c'est-à-dire que l'on s'éloigne de l'électrode de grille. Il y a donc une concentration décroissante en première impureté dopante dans le premier film en matériau semi-conducteur 2a depuis l'interface entre le premier film semi-conducteur 2a avec la couche électriquement isolante 3.

L'homme du métier tiendra également compte de la dose et de la nature de l'élément implanté afin d'éviter l'amorphisation du second film semi-conducteur 4 et éventuellement du premier film semi-conducteur 2a. Cependant, si une dose importante est nécessaire, cette dernière peut être divisée en une pluralité de doses élémentaires séparées par une étape de recuit afin de réduire les risques d'amorphisation. De manière préférentielle, les conditions opératoires de l'implantation sont choisies de manière à ce que la concentration en première impureté dopante soit supérieure ou égale à $10^{18}$ atomes/cm$^3$ à l'interface entre la couche 3 et le film 2a, mais cette valeur peut varier en fonction de la distance entre la contre-électrode 8 et le film semi-conducteur 4.

Ce profil particulier de concentration est obtenu en utilisant une énergie d'implantation faible qui incorpore également la première impureté dopante dans la couche en matériau semi-conducteur 4 au niveau des zones non protégées et/ou dans la couche électriquement isolante 3. La technique d'implantation utilisée est conventionnelle avec une énergie d'implantation plus faible que dans l'art antérieur afin de placer le maximum de concentration dans le film semi-conducteur 4 ou dans la couche électriquement isolante 3.

Le fait de réaliser la contre-électrode 8 après la formation de l'électrode de grille 5 permet de réduire l'étendue en profondeur de la contre-électrode 8 dans le substrat de support 2. Dans l'art antérieur, l'étendue en profondeur provient de l'utilisation de fortes énergies d'implantation (typiquement de l'ordre de 100KeV) pour ne pas implanter d'impuretés dopantes dans le canal et également de l'utilisation de la diffusion liée aux budgets thermiques afin de lisser le profil des dopants. La réalisation tardive de la contre-électrode 8 dans le procédé

de mise en œuvre permet également de retarder l'implantation du motif d'isolation 7 ce qui a pour effet de le rendre plus résistant aux différents procédés de gravure humide et d'améliorer la fiabilité du dispositif final.

De manière préférentielle, l'étape d'implantation est réalisée pour des longueurs de grilles inférieures à 50nm ce qui permet d'utiliser des angles d'implantation faibles et de réaliser facilement une contre-électrode dopée continue sous l'électrode de grille et donc face au canal de conduction directement après implantation.

De manière préférentielle également, l'utilisation d'un substrat à films minces c'est-à-dire d'un substrat dont l'épaisseur totale du film 4 avec la couche 3 est inférieure à 40nm permet d'utiliser de faibles énergies d'implantation. Dans cette gamme d'énergie, il est avantageux de profiter des espaceurs latéraux 9 de l'électrode de grille 5 pour protéger le diélectrique de grille 6 et le canal de conduction d'une implantation parasite. Il est alors facile de réaliser l'implantation sans ajouter des couches de protection au dispositif.

Dans un mode de réalisation particulier illustré à la figure 4, les conditions d'implantation sont choisies de manière à avoir le maximum de la concentration en première impureté dopante implanté dans le film 4 en matériau semi-conducteur. Dans ce cas de figure, la concentration en première impureté dopante décroît continûment à travers la couche électriquement isolante 3 et le substrat de support 2.

La couche électriquement isolante 3 est alors dopée sous les électrodes de source et drain 6 et elle présente une portion non dopée sous le canal de conduction.

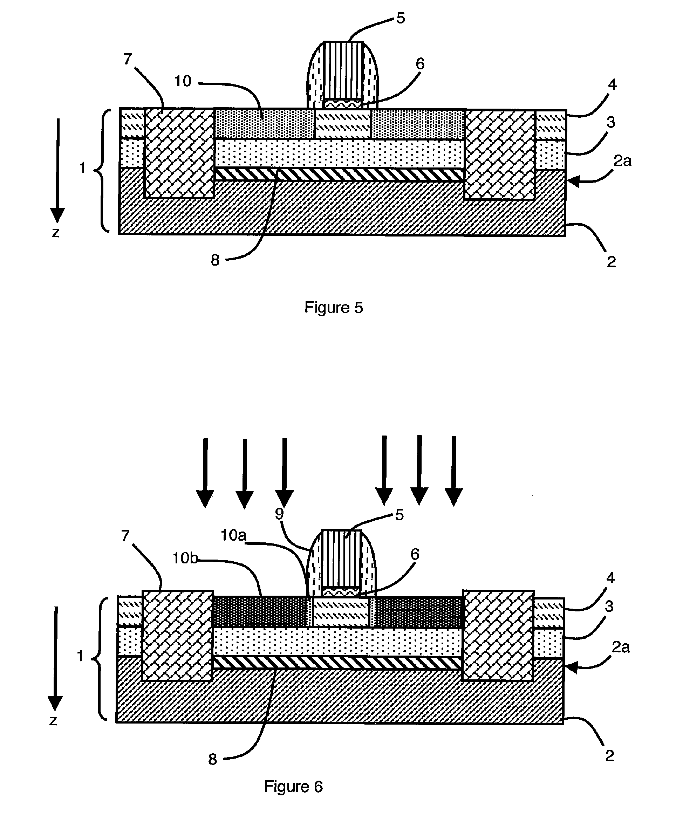

Comme illustré à la figure 5, l'étape d'implantation de la première impureté dopante peut être utilisée pour définir la contre-électrode 8 et les électrodes 10 de source et drain. Les électrodes 10 de source et drain du transistor sont alors du même type de conductivité que la contre-électrode 8.

De manière encore plus préférentielle et illustrée à la figure 6, cette étape d'implantation commune forme les zones de dopage intermédiaire 10a qui existent entre les zones très dopées 10b des électrodes 10 de source/drain et le canal de conduction. Cette première étape d'implantation est alors suivie par une étape d'implantation additionnelle, généralement perpendiculaire à la surface du substrat 1, de manière à former deux zones extrêmement dopées sur lesquelles les contacts de source et de drain seront réalisés. Les deux étapes d'implantation sont réalisées avec la même impureté dopante ou avec des impuretés de même type. Les électrodes de source/drain comportent chacune une zone de dopage intermédiaire 10a qui est disposée entre le canal de conduction et une zone plus dopée 10b qui sert à la prise des futurs contacts de source/drain. Cette zone de dopage intermédiaire 10a permet d'obtenir des dispositifs plus fiables, par exemple, en réduisant les risques de porteurs chauds.

La concentration en première impureté dopante dans les première et seconde électrodes 10 de source/ drain est continûment décroissante depuis le film en matériau semi-conducteur 4 jusqu'au substrat de support 2.

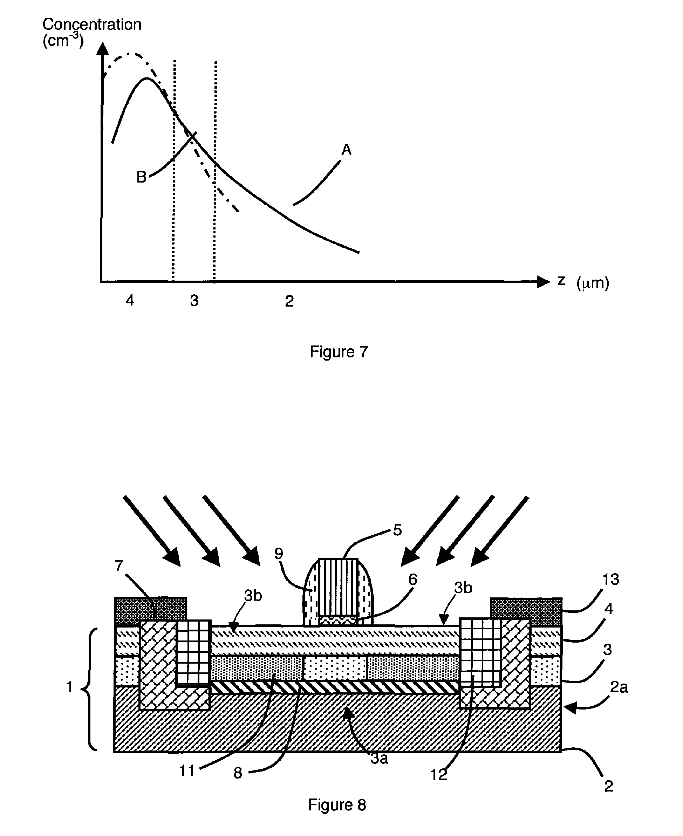

Ce mode de réalisation est particulièrement intéressant car il permet de former, avec un faible nombre d'étapes, les électrodes 10 de source/drain et la contre-électrode 8. A titre d'exemple, le profil de dopant illustré à la figure 4 représente le profil de dopants depuis une électrode de source/drain jusqu'au substrat de support. Comme illustré à la figure 7, une implantation additionnelle peut être réalisée dans les zones de source/drain pour former les électrodes de source/drain avec le profil de dopants recherché. Le profil de dopants illustré par la courbe A correspond par exemple à une implantation tiltée formant simultanément la contre-électrode 8 et des zones de dopage intermédiaires sous les espaceurs latéraux. La courbe B correspond par exemple, à une implantation supplémentaire verticale de manière à former les zones plus dopées des électrodes de source/drain. Les conditions d'implantation étant différentes, les dopants provenant de l'implantation supplémentaire interviennent peu dans la formation de la contre-électrode. Des impuretés dopantes identiques ou du même type de conductivité sont implantées pour former les courbes A et B.

Dans un autre mode de mise en oeuvre, les électrodes 10 de source/drain sont d'un type de conductivité opposé à celui de la contre-électrode 8. Une seconde impureté dopante de type opposé à la première impureté dopante est alors implantée dans les électrodes 10 de source/drain de manière à obtenir un type de conductivité opposé. Il existe alors un premier profil de dopage lié à la première impureté dopante et un second profil de dopage lié à la seconde impureté dopante de type opposé. Comme précédemment, plusieurs implantations sont possibles afin de former dans les électrodes de source/drain une zone fortement dopée et une zone de dopage intermédiaire. Le profil de dopage illustré à la figure 7 peut également représenter cette configuration, mais des impuretés de types opposés sont utilisées entre les courbes A et B. Le type d'impureté associé à la courbe A correspond au type de la contre-électrode 8. Dans le cas illustré, les électrodes de source et drain présentent les deux types d'impuretés opposées ainsi que la contre-électrode.

La première impureté dopante est majoritaire par rapport à la seconde impureté dopante dans le substrat de support 2 pour former la contre-électrode 8. La première impureté dopante a une concentration décroissante depuis l'interface entre la couche électriquement isolante 3 et le premier film semi-conducteur 2a. La seconde impureté à une concentration également décroissante et toujours inférieure à celle de la première impureté ou la seconde impureté est absente car elle a été arrêtée par la couche électriquement isolante 3 ou elle est en concentration nettement inférieure.

La seconde impureté dopante est majoritaire par rapport à la première impureté dopante dans le second film semi-conducteur 4 afin d'imposer le second type de conductivité dans les électrodes 10 de source/ drain.

De manière préférentielle, les conditions d'implantation sont choisies pour que la seconde impureté dopante présente une concentration fortement décroissante dans la couche électriquement isolante 3. De cette manière, la seconde impureté dopante joue un rôle négligeable dans le fonctionnement de la contre-électrode 8.

De manière également préférentielle, les conditions d'implantation sont choisies pour que la première impureté dopante présente une concentration maximale dans la couche électriquement isolante 3. De préférence, la première impureté dopante n'est pas présente dans le film semi-conducteur 4 de manière à avoir un rôle négligeable dans le fonctionnement des électrodes 10 de source et de drain.

Cette approche permet de former facilement une pluralité de transistors ayant chacun une contre-électrode spécifique. Grâce à un jeu de masquage aisé, il est possible de co-intégrer des transistors ayant des électrodes de source/drain ayant le même type de conductivité que leur contre-électrode de type N ou de type P.

Il est également possible de co-intégrer aisément des transistors ayant des électrodes 10 de source/ drain d'un premier type de conductivité et une contre-électrode 8 d'un type opposé à côté de transistors ayant le même type de conductivité pour leurs électrodes 10 de source/drain et leur contre-électrode. L'étape de formation de la contre-électrode peut être commune si toutes les électrodes sont du même type de conductivité. Il suffit alors de réaliser la différenciation des transistors au moyen d'une étape additionnelle d'implantation des électrodes 10 de source/drain pour obtenir des électrodes 10 de source/drain différentes selon les transistors.

Il est encore possible de combiner ces différents modes de réalisation de manière à obtenir sur un même substrat des transistors complètement différents en mutualisant les étapes d'implantation. Une première implantation est utilisée pour former une contre-électrode 8 de type N quel que soit le type du transistor final. Une seconde implantation est utilisée pour former une contre-électrode 8 de type P quel que soit le type du transistor final. Ensuite deux autres implantations sont utilisées pour former les électrodes 10 de source/drain du type recherché.

Selon l'angle d'implantation utilisé, le profil de concentration en dopants dans la contre-électrode varie avec la position. En choisissant un angle d'implantation important, la zone du substrat de support 2 faisant face au canal de conduction est implantée depuis chaque côté de la grille, c'est-à-dire depuis la zone de source et depuis la zone de drain. La concentration en élément dopant est plus importante sous le canal de conduction que sous les électrodes de source et de drain 6 tout en conservant le profil recherché. Ce profil est préférable pour diminuer le couplage avec les électrodes de source et drain tout en conservant un couplage important avec le canal de conduction. Ce profil de dopage particulier permet de conserver un couplage électrostatique fort sous le canal de conduction et de réduire également la quantité de dopants présents à proximité immédiate du motif d'isolation afin de réduire l'influence de la contre-électrode sur les dispositifs voisins. En d'autres termes, la contre-électrode 8 comporte une première concentration en première impureté dopante face à l'électrode de grille et une seconde concentration en première impureté dopante face aux électrodes de source/drain, la seconde concentration étant inférieure à la première concentration

En choisissant un angle d'implantation plus faible, il est possible d'avoir un profil opposé c'est-à-dire une concentration plus élevée sous les électrodes de source et drain 6 en comparaison de ce qui est présent sous le canal.

Un tel profil de concentration peut également être obtenu au moyen d'une implantation verticale additionnelle, par exemple l'implantation verticale utilisée pour former les électrodes de source et de drain 6.

Dans un mode de réalisation particulier, l'utilisation d'un masque d'implantation comportant une partie en résine disposée à la périphérie de la zone active sur le film semi-conducteur et/ou sur le motif d'isolation peut limiter l'étendue latérale de la contre-électrode et/ou la quantité de dopants à proximité immédiate du motif d'isolation 7. Cela permet de réduire l'influence de la contre-électrode 8 sur les dispositifs adjacents.

Dans les modes de réalisation particuliers décrit ci-dessus, la couche électriquement isolante 3 comporte une partie dopée. La zone dopée de la couche électriquement isolante 3 peut être utilisée comme un matériau différent du reste de la couche 3 et qui peut être gravé sélectivement par rapport au matériau non dopé.

Dans un autre mode de réalisation, cette particularité permet de former un dispositif ayant des performances électriques améliorées, la couche électriquement isolante 3 présente des zones distinctes à cause du dopage. Cette différence de comportement permet, par la suite, de former une couche 3 hétérogène avec trois zones distinctes. Ces zones distinctes forment différents condensateurs. Il y a un premier condensateur dont les électrodes sont formées par le canal et le substrat de support 2 et sont séparées par la couche électriquement isolante 3. Des deuxième et troisième condensateurs sont présents et comportent successivement le substrat de support 2, la couche électriquement isolante 3 et les électrodes de source ou de drain 6. Les capacités de couplage du transistor avec le substrat de support 2 sont différentes entre le canal de conduction et les électrodes de source/drain. La couche isolante 3 peut être découpée en trois zones, chaque zone étant associée à une partie spécifique transistor (du film semi-conducteur 2) de manière à former un condensateur.

La valeur de la capacité de couplage des condensateurs est mesurée entre le substrat de support 2 et le film semi-conducteur 4 dans les portions se faisant face. La valeur de la capacité de couplage prend en compte les différents matériaux que l'on trouve entre le substrat de support 2 et le film semi-conducteur 4 ainsi que leur épaisseur. La valeur de la capacité de couplage prend également en compte la surface des électrodes se faisant face.

La première zone 3a est disposée face à l'électrode de grille 5, ici sous l'électrode de grille et donc sous le canal de conduction. La première zone 3a présente une première valeur de constante diélectrique entre le substrat de support 2 et le film semi-conducteur 4. La première zone 3a fait partie du premier condensateur avec une première valeur de capacité de couplage par unité de surface.

Une deuxième zone 3b est disposée face à l'électrode de source et elle présente une deuxième valeur de constante diélectrique. La deuxième zone 3b fait partie du deuxième condensateur avec une deuxième valeur de capacité de couplage par unité de surface. La deuxième valeur de capacité de couplage par unité de surface est inférieure à la première valeur de capacité de couplage par unité de surface. Cette différence entre les première et deuxième valeurs de capacité de couplage peut provenir du fait que la valeur de la constante diélectrique de la couche électriquement isolante 3 dans la deuxième zone est inférieure à la première valeur de constante diélectrique dans la première zone 3a, la distance séparant les électrodes étant identique entre les zones 3a et 3b. Cette différence peut provenir également du fait que la distance qui sépare les deux électrodes est plus importante dans la seconde zone 3b que dans la première 3a, le matériau formant la couche électriquement isolante étant identique dans les première et deuxième zones 3a et 3b. Cette différence de capacité de couplage peut provenir encore d'une combinaison des deux cas précédents.

Une troisième zone 3c est disposée face à l'électrode de drain et elle présente une troisième valeur de capacité de couplage par unité de surface. La troisième valeur de capacité de couplage par unité de surface est inférieure à la première valeur de capacité de couplage par unité de surface. La différence entre les première et troisième valeurs de capacité de couplage par unité de surface peut provenir des mêmes raisons que celles expliquées plus haut pour la deuxième capacité de couplage.

Dans la suite de la description, le terme capacité de couplage par unité de surface est remplacé par le terme capacité de couplage. La capacité de couplage par unité de surface correspond au rapport entre la permittivité du diélectrique présent entre les deux électrodes du condensateur et la distance qui sépare les électrodes. Cette architecture permet de diminuer la capacité de couplage (en modifiant la capacité de couplage par unité de surface) sans modifier le dessin du transistor.

La différence de capacité de couplage est observée entre le film semi-conducteur 4 et le substrat de support 2, c'est-à-dire qu'elle provient d'une différence d'épaisseur entre les zones en regard et/ou d'une différence de matériau utilisé entre les deux électrodes du condensateur ce qui se traduit par une différence du rapport permittivité sur épaisseur (ε/e).

La couche électriquement isolante 3 est modifiée par implantation pour former deux matériaux différents présentant entre eux une sélectivité de gravure. Un matériau sacrificiel 11 est formé lors de l'implantation de l'impureté dopante de la contre-électrode 8. Le matériau sacrificiel 11 est formé par implantation dans le matériau formant initialement la couche électriquement isolante 3. Après l'étape d'implantation, il y a dans la couche 3 des zones en matériau sacrificiel 11 et des zones en matériau à conserver.

Dans une variante de réalisation qui peut être combinée avec le mode précédent, le matériau sacrificiel est formé lors de l'implantation verticale des électrodes de source/drain. Dans ce cas de figure, un matériau nouveau est formé sous les zones découvertes.

Le masque d'implantation utilisé comporte l'électrode de grille 5. Dans certains modes particuliers de réalisation, le masque d'implantation peut également contenir d'autres motifs formés, par exemple, au moyen d'une résine photosensible. La résine photosensible peut être utilisée, par exemple, pour limiter le dopage du motif d'isolation 7 car le dopage peut le rendre plus sensible aux étapes ultérieures de gravure par voie humide.

Dans un mode de réalisation particulier illustré également à la figure 8, l'étape d'implantation forme également un matériau sacrificiel additionnel 12 dans le motif d'isolation 7. Dans une variante de réalisation également illustrée à la figure 8, le masque d'implantation est réalisé en partie par l'électrode de grille 5 et en partie par une résine 13. A titre d'exemple, la résine 13 forme un motif au-dessus du motif d'isolation 7 afin de limiter l'étendue du matériau sacrificiel additionnel 12 dans le motif d'isolation 7 tout en conservant l'auto-alignement de la première zone 3a par rapport à la grille 5.

Comme l'électrode de grille 5 est utilisée comme masque d'implantation, il y a un auto-alignement de l'électrode de grille 5 avec la première zone 3a où le matériau de la couche électriquement isolante est conservé. Selon les modes de réalisation, l'implantation peut être réalisée avec un angle d'implantation plus ou moins important. Les variations dans les conditions d'implantation (angle d'implantation, énergie d'implantation, dose implantée) permet de définir les dimensions de la zone 3a par rapport aux dimensions de l'électrode de grille 5 avec éventuellement ses espaceurs latéraux 9.

A titre d'exemple, pour une couche électriquement isolante 3 en oxyde de silicium, une implantation d'arsenic ou d'indium est réalisée afin de former un oxyde de silicium dopé qui se grave à une vitesse plus importante que l'oxyde de silicium non dopé. La gravure est avantageusement réalisée au moyen d'acide fluorhydrique, préférentiellement sous forme de HF anhydre gazeux.

Dans le cas où le motif d'isolation 7 est dans le même matériau que la couche électriquement isolante 3, le matériau sacrificiel 11 et le matériau sacrificiel additionnel 12 sont identiques et réagissent à la même chimie de gravure. Il est alors possible de former un chemin de dégradation préférentiel du matériau sacrificiel 11 en passant par le motif d'isolation 7. L'étendue de la gravure parasite dans le motif d'isolation 7 est liée à la sélectivité de gravure qui existe entre le matériau sacrificiel 11 et le matériau formant le motif d'isolation 7 et la zone 3a.

Quand l'électrode de grille 5 est utilisée en tant que masque d'implantation, il est avantageux de réaliser l'opération de formation du matériau sacrificiel 11 en même temps que la formation des électrodes de source et de drain et de la contre-électrode 8 si le matériau dopant est implanté avec une concentration telle qu'il autorise la formation du matériau sacrificiel 11.

Dans ce cas de figure, après l'étape d'implantation, la zone 3a est disposée sous l'électrode de grille 5 et correspond au volume de la couche isolante 3 qui n'a pas été implantée. La seconde portion de la couche 3 en matériau sacrificiel 11 correspond aux zones 3b et 3c et elle est disposée sous les électrodes 10 de source et de drain.

Ces deux portions sont formées par des matériaux différents et réagissent à des chimies de gravure différentes et/ou à la même chimie de gravure, mais avec des vitesses différentes de manière à obtenir une certaine sélectivité de gravure.

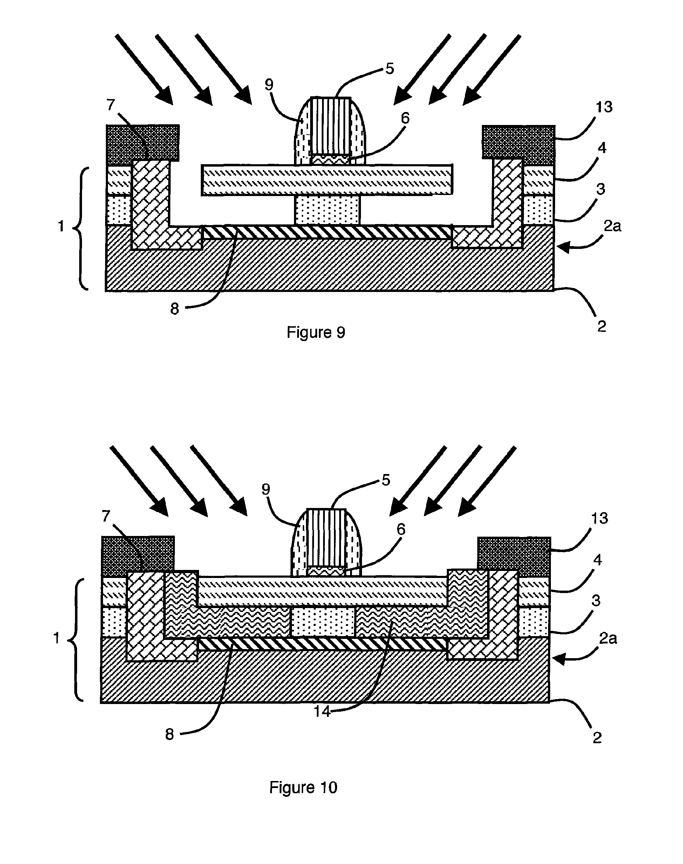

Comme cela est illustré à la figure 9, un premier trou est formé dans le motif d'isolation 7 et/ou dans le film semi-conducteur 4 pour avoir accès à la seconde zone 3b de la couche électriquement isolante 3. Un second trou est formé dans le motif d'isolation et/ou dans le film semi-conducteur 4 pour avoir accès à la troisième zone 3c de la couche électriquement isolante 3.

Dans un mode de réalisation non représenté, le trou est formé par l'élimination complète du motif d'isolation 7 sur une partie de son épaisseur de manière à atteindre le matériau sacrificiel 11 et/ou le matériau sacrificiel additionnel 12. La partie supérieure du motif d'isolation 7 peut être éliminée de manière isotrope ou anisotrope pour permettre l'accès au matériau sacrificiel additionnel 12 qui donnera ensuite accès au matériau sacrificiel 11.

Il est également possible d'utiliser un motif en résine 11 pour éliminer toute la surface du motif d'isolation en formant ou non le matériau sacrificiel 12.

Dans le mode de réalisation illustré à la figure 8, le trou est formé par l'élimination d'une partie de la surface du motif d'isolation 7 pour atteindre le matériau sacrificiel 11 et/ou le matériau sacrificiel additionnel 12. Dans l'exemple illustré, seule une partie du motif d'isolation 7 est accessible et gravée. Cette gravure localisée est obtenue par exemple au moyen d'un masque de gravure associé à une gravure anisotrope, mais une gravure isotrope est également possible.

La forme et la surface du trou sont quelconques dans la mesure où le trou autorise l'accès à la zone sacrificielle 11.

En variante, il est également envisageable de ne former qu'un seul trou qui donne accès simultanément aux deux zones 3b et 3c. Dans un mode de mise en oeuvre particulier, le motif d'isolation 7 est éliminé autour du transistor jusqu'à atteindre les seconde 3b et troisième 3c zones de la couche d'isolation 3.

De préférence, le trou est formé dans le motif d'isolation 7 car cela permet de relâcher les contraintes dimensionnelles et d'alignement pour assurer un accès à la couche électriquement isolante 3. Lorsque le trou est formé dans le motif d'isolation 7 ou par élimination du motif d'isolation 7, il est préférable de former le matériau sacrificiel additionnel 12 ce qui permet d'avoir une plus grande souplesse dans le procédé de dégradation à venir.

Dans une autre variante de réalisation, il est envisageable de former des électrodes 6 de source/drain qui sont partiellement en silicium ou siliciure poreux afin d'autoriser l'accès à la couche sacrificielle 11 sans former de trou dans le motif d'isolation 7, ni dans les électrodes de source/drain.

Comme cela est illustré à la figure 9, une fois que la seconde 3b et la troisième 3c zones de la couche d'isolation 3 sont accessibles, ces deux zones sont éliminées au moyen d'une chimie de gravure adaptée.

De cette manière, la première zone 3a est conservée entre l'électrode de grille 5 et le substrat de support 2 et les deuxième 3b et troisième 3c zones sont formées par des zones vides. La première zone 3a forme une zone de maintien mécanique qui permet aux zones de source et de drain d'être suspendues au-dessus du substrat de support 2. Les zones suspendues sont de chaque côté de la zone de maintien 3a. Grâce à la sélectivité de gravure qui existe entre le matériau sacrificiel 11 et le matériau à conserver, la zone de maintien est disposée face à l'électrode de grille 5, le long de l'électrode de grille. La zone de maintien supporte au moins partiellement le transistor durant tout le procédé.

Dans une variante de réalisation, l'élimination des deuxième 3b et troisième 3c zones de la couche d'isolation 3 est réalisée par toutes techniques adaptées, par exemple au moyen d'une dégradation thermique ou d'une dégradation par un rayonnement électromagnétique ou électronique. A titre d'exemple, ces techniques sont utilisées pour former des structures d'interconnexion avec des cavités d'air (air-gap en anglais). Le trou formé sert alors à l'évacuation du sous-produit de dégradation.

Dans encore une autre variante, le trou n'est pas nécessaire si un matériau électriquement isolant poreux est présent dans la zone d'isolation 7 et permet le passage d'un agent de dégradation et/ou du sous-produit de dégradation vers la couche électriquement isolante 3. A titre d'exemple, deux catégories de matériaux peuvent être envisagées, des oxydes de silicium dopés par de l'hydrogène, du carbone ou du fluor et qui sont typiquement notés sous la forme SiOCH, SiCH ou SiOF et des polymères organiques poreux ne contenant pas de silicium tels que des matériaux à base de carbone, par exemple une matrice carbone qui est dopée par de l'hydrogène et notée CH ou une matrice carbone dopée par du fluor et notée CF.

Il est également possible d'utiliser un matériau perméable à l'agent de dégradation et/ou au sous-produit de dégradation à la place du trou et du matériau poreux. Le matériau poreux ou perméable évite la formation d'un trou ce qui permet de conserver une fiabilité élevée du dispositif.

Une fois la couche électriquement isolante 3 partiellement éliminée, ici avec l'élimination du matériau sacrificiel 11, elle présente des zones avec des constantes diélectriques différentes selon les critères définis plus haut.

Le dispositif à effet de champ est isolé électriquement du substrat de support 2 et les électrodes 10 de source/drain n'ont pas, en vis-à-vis, le même matériau diélectrique que le canal de conduction.

Dans ce mode de réalisation, les portions du film semi-conducteur 4 formant les électrodes de source et de drain sont suspendues. Cette configuration permet de relâcher au moins partiellement les contraintes présentes initialement ou induites par le procédé de fabrication. Le film semi-conducteur 4 est maintenu en suspension au moyen de la partie de la couche électriquement isolante qui est face au canal ce qui permet de maintenir le jeu de contraintes dans le canal de conduction.

La relaxation du jeu de contraintes peut être complète ou presque complète si le motif d'isolation 7 est gravé de manière à réduire son épaisseur autour de la zone active du transistor pour accéder à la couche électriquement isolante 3. Les parois latérales du film semi-conducteur sont libres. La relaxation du jeu de contraintes peut être partielle si l'accès à la couche électriquement isolante est obtenu au moyen d'un trou formé dans le motif d'isolation ou dans le film semi-conducteur 4 qui limite les éventuelles déformations du film semi-conducteur pour se relaxer. Il peut également y avoir transformation ou conservation du jeu de contraintes initiales si l'accès à la couche électriquement isolante 3 est obtenue grâce à un matériau poreux, le motif d'isolation 7 restant en contact du film semi-conducteur 4.

Dans un mode particulier de mise en oeuvre illustré à la figure 10, il est ensuite possible de remplir les zones vides par un matériau isolant additionnel 14 différent du matériau constituant la zone 3a de manière à renforcer la fiabilité électrique et la stabilité mécanique de la structure tout en conservant de bonnes propriétés électrostatiques. Ce matériau isolant additionnel 14 est, par exemple, un matériau dont la constante diélectrique est inférieure à celle de l'oxyde de silicium comme, avantageusement, un matériau poreux. Le matériau isolant additionnel est par exemple déposé à la tournette.

Lorsque la zone vide est remplie par un nouveau matériau 14 isolant, il est possible d'introduire un nouveau jeu de contraintes dans les électrodes de source et de drain et dans une moindre mesure dans le canal de conduction. Au moyen de ce mode de réalisation, il est alors possible de former un transistor avec un jeu de contraintes complexe. Le canal et les électrodes de source/drain sont soumis à des jeux de contraintes différents. Ce mode de réalisation permet de co-intégrer simplement deux transistors ayant des jeux de contraintes différents.

Ce mode de réalisation est particulièrement intéressant car il permet facilement de délimiter les zones à éliminer et de réaliser l'auto-alignement par rapport au canal de conduction. Ainsi, le jeu de contraintes peut rester symétrique par rapport au canal de conduction.

Dans un autre mode de mise en oeuvre qui peut être combiné aux modes précédents, il est possible de graver partiellement, le substrat de support 2 et/ou le film semi-conducteur 4 mis à découvert afin d'accroître la distance entre ces deux couches. L'augmentation de la distance permet de favoriser l'obtention d'une capacité plus faible sous les électrodes de source/drain comparée au canal de conduction dans le cas où le même matériau est présent en face du canal et des électrodes 10 de source/drain. Il est également possible d'utiliser des matériaux différents pour avoir un effet plus marqué.

Comme indiqué plus haut, différentes techniques sont envisageables pour avoir un accès aux secondes et troisièmes zones de la couche d'isolation 3. Il est également possible de former un accès simultané aux deux zones 3b et 3c ou des accès consécutifs. Dans les modes de réalisation décrits ci-dessus, il y a un accès simultané aux zones 3b et 3c de manière à les vider durant la même étape technologique et éventuellement les remplir en même temps.

Il est également envisageable de les vider consécutivement en utilisant des masques différents pour accéder à la zone de source ou à la zone de drain. Il est encore possible d'utiliser un seul masque avec un bouchon qui masque une des deux zones.

Il est encore possible de remplir les zones, en même temps, avec le même matériau ou bien d'utiliser des matériaux différents. Si des matériaux différents sont utilisés entre la source et le drain, il est intéressant d'éliminer consécutivement les zones 3b et 3c pour les remplir au fur et à mesure ou d'utiliser un bouchon pour protéger une zone pendant que l'autre est remplie par l'isolant désiré. Ce mode de réalisation permet de former la zone 3b avec un matériau particulier et la zone 3c avec un matériau différent.

Le masque d'implantation peut également être utilisé en tant que masque de gravure avec une gravure anisotrope en choisissant de graver le motif d'isolation 7 dans la zone découverte jusqu'à atteindre le matériau sacrificiel 11 et/ou le matériau sacrificiel additionnel 12.

De manière avantageuse, le trou qui a permis l'accès aux matériaux sacrificiels 11, 12 est rempli de façon à empêcher que des poussières ne restent coincées dans le trou ce qui est préjudiciable à la fiabilité du dispositif. Ce cas de figure est particulièrement intéressant lorsque l'accès à la couche électriquement isolante 3 a été réalisé à travers le motif d'isolation 7 ce qui entraîne généralement la présence d'un trou de taille importante. L'utilisation d'un transistor ayant une capacité plus faible sous les électrodes de source et drain comparée à ce qui est présent sous l'électrode de grille 5 permet de réduire le couplage électrostatique entre les électrodes de source/drain et le substrat 2 et donc d'obtenir un transistor plus rapide qu'avec un film isolant 3 homogène. La conservation d'une capacité plus élevée sous le canal de conduction permet de garder un couplage électrostatique important avec le substrat de support 2. Cette configuration est particulièrement intéressante lorsqu'une contre-électrode 8 est utilisée dans le substrat de support 2. Cette architecture permet simultanément de diminuer les capacités parasites au niveau des électrodes 10 de source et de drain tout en faisant bénéficier le transistor d'une bonne maîtrise des effets de canaux courts et des effets de modulation de tension de seuil. Cette architecture permet d'améliorer les performances dynamiques du transistor sans dégrader ses performances statiques.

La couche électriquement isolante 3 peut être formée par un seul matériau qui est présent entre le substrat de support 2 et le film semi-conducteur 4 en face des différentes électrodes. Le matériau présente alors des épaisseurs variables de manière à avoir un couplage plus faible au niveau des électrodes de source/drain comparé au couplage dans le canal de conduction.

La couche électriquement isolante 3 peut également être formée par un empilement de plusieurs couches avec des épaisseurs variables selon les zones afin d'obtenir une variation de la constante diélectrique globale. L'empilement de couches a lieu dans une direction qui relie la couche de support 2 au film semi-conducteur 4.

Il est possible de combiner les deux modes de réalisation précédents afin d'avoir une couche électriquement isolante comportant différents constituants et différents matériaux sous la grille 5 et sous les électrodes 10 de source/drain.

Dans encore un autre mode de réalisation qui peut être combiné aux précédents, la variation de capacité peut également provenir de l'utilisation de matériaux différents selon les condensateurs. Ainsi, à titre d'exemple, un premier matériau électriquement isolant est utilisé sous l'électrode de grille 5 avec une première constante diélectrique. Ce premier matériau forme la couche électriquement isolante dans la zone 3a. Un deuxième matériau électriquement isolant est utilisé sous l'électrode de source et forme la couche électriquement isolante dans la zone 3b. Un troisième matériau électriquement isolant est utilisé sous l'électrode de drain et forme la couche électriquement isolante dans la zone 3c. Il y a alors un empilement de couches dans une direction parallèle à l'axe reliant l'électrode de source à l'électrode de drain. Les deuxième et troisième matériaux sont choisis de manière à avoir une constante diélectrique inférieure à celle du premier matériau si l'épaisseur entre les trois zones est identique.

Dans un mode particulier de réalisation, l'épaisseur de la couche électriquement isolante 3 est constante et il y a des matériaux différents qui sont utilisés pour définir les différentes zones 3a, 3b et 3c. Dans un cas particulier de réalisation, les zones 3b et 3c sont formées par le même matériau et la zone 3a est formée par un autre matériau.

Selon les modes de réalisation employés, la différence de capacité entre les différentes zones 3a, 3b et 3c peut provenir de l'utilisation de plusieurs couches ayant des constantes diélectrique différentes. La différence de capacité peut encore être obtenue en utilisant des films identiques, mais avec des épaisseurs différentes. Comme indiqué plus haut, il est également possible de combiner ces deux modes de réalisation.

Dans un mode de réalisation privilégié, la valeur de la seconde capacité est égale à celle de la troisième capacité (à surfaces égales). Ces deux zones peuvent alors avoir des matériaux identiques avec la même épaisseur ou des épaisseurs différentes avec des matériaux compensant cette différence d'épaisseur.

Dans un mode de réalisation encore plus privilégié qui peut être combiné avec le mode précédent, la deuxième 3b et/ou la troisième zone 3c peut comporter une zone vide ou être constituée par une zone vide. L'utilisation d'une zone vide permet d'obtenir facilement une faible constante diélectrique et donc un faible couplage face aux électrodes 10 de source et drain. La zone vide est une zone isolante qui peut être formée par un élément gazeux avec une pression prédéterminée, par exemple un gaz à pression subatmosphérique. L'électrode de source et/ou l'électrode de drain est alors suspendue au-dessus du substrat de support 2 et la zone 3a sert de zone de maintien mécanique.

Dans un mode de réalisation qui peut être combiné avec les modes de réalisation précédents, le substrat de support 2 comporte une contre-électrode 8 qui est formée en face de l'électrode de grille 5 et avantageusement en face des électrodes 10 de source et de drain. La contre-électrode 8 permet de modifier le fonctionnement du transistor en modulant le couplage avec le canal de conduction.

De manière avantageuse, le motif d'isolation 7 entoure le transistor et bouche l'accès à la deuxième 3b et/ou à la troisième 3c zones lorsque celle-ci est vide. La zone vide est délimitée par le substrat de support 2 et le film semi-conducteur 4. Elle est délimitée latéralement par la première zone 3a et par le motif d'isolation 7 au moyen d'une paroi latérale du motif d'isolation 7 qui relie le film semi-conducteur 4 au substrat de support 2. Cette paroi latérale est préférentiellement plane. Cette configuration ne permet pas d'avoir accès à la zone vide tout au long du procédé de mise en oeuvre ce qui augmente la fiabilité du transistor en réduisant les risques de pollution parasite coincée dans la zone vide. Il peut en être de même lorsque la deuxième 3b et/ou la troisième 3c zones comporte un volume vide, par exemple lorsque les zones 3b et/ou 3c sont formées en partie par un matériau solide isolant et par un volume vide.

**Revendications**

1.  Dispositif à effet de champ comportant :

    - un substrat (1) de type semi-conducteur sur isolant muni successivement d'un substrat de support (2), d'une couche électriquement isolante (3) et d'un film en matériau semi-conducteur (4),
    - des première et seconde électrodes (10) de source/drain formées dans la couche en matériau semi-conducteur (4),
    - un canal de conduction formé dans la couche en matériau semi-conducteur (4) et séparant les première et seconde électrodes (10) de source/drain,
    - une contre-électrode (8) formée dans le substrat de support (2) et faisant face aux première et seconde électrodes (10) de source/drain et au canal de conduction,
    dispositif **caractérisé en ce que** la contre-électrode (8) est formée par une zone dopée du substrat de support (2) ayant une concentration en première impureté dopante décroissante depuis une interface entre la couche électriquement isolante (3) et le substrat de support (2).

2.  Dispositif selon la revendication 1 **caractérisé en ce que** la contre-électrode (8) est du même type de conductivité que les électrodes (10) de source/drain, la concentration en première impureté dopante dans les première et seconde électrodes (10) de source/drain étant continûment décroissante depuis le film en matériau semi-conducteur (4) jusqu'au substrat de support (2).

3.  Dispositif selon la revendication 2 **caractérisé en ce que** les électrodes (10) de source/ drain comportent une zone de dopage intermédiaire disposée entre le canal de conduction et une zone de prise de contact, la concentration en première impureté dopante dans les première et seconde électrodes (10) de source/drain étant continûment décroissante depuis la zone de dopage intermédiaire jusqu'au substrat de support (2)

4.  Dispositif selon la revendication 1 **caractérisé en ce que** la contre-électrode (8) est d'un type de conductivité opposé à celui des électrodes (10) de source/drain, la concentration en première impureté dopante dans les première et seconde électrodes (10) de source/drain est supérieure à la concentration en première impureté dopante à l'interface entre la couche électriquement isolante (3) et le film en matériau semi-conducteur (4) et est supérieure à la concentration en seconde impureté dopante dans les première et seconde électrodes (10) de source/drain.

**5.** Dispositif selon l'une quelconque des revendications 1 à 4, **caractérisé en ce que** la contre-électrode (8) comporte une première concentration en première impureté dopante face à l'électrode de grille (5) et une seconde concentration en première impureté dopante face aux électrodes de source/drain, la seconde concentration étant inférieure à la première concentration.

**6.** Dispositif selon l'une quelconque des revendications 1 à 5, **caractérisé en ce que** la couche électriquement isolante (3) comporte une zone vide face à une des électrodes de source/drain.

**7.** Procédé de fabrication d'un dispositif à effet de champ **caractérisé en ce qu'**il comporte :

- prévoir un substrat (1) muni successivement d'un substrat de support (2) avec un premier film en matériau semi-conducteur (2a), une couche électriquement isolante (3), un second film en matériau semi-conducteur (4), une électrode de grille (5) séparée du second film en matériau semi-conducteur (4) par un diélectrique de grille (6),

- réaliser une implantation ionique d'une première impureté dopante avec un angle non nul par rapport à la surface du second film en matériau semi-conducteur (4) de manière à former dans le premier film en matériau semi-conducteur (2a) une zone dopée d'un premier type de conductivité en face de l'électrode de grille (5), la concentration en première impureté dopante diminuant à partir de l'interface entre le premier film en matériau semi-conducteur (2a) et la couche électriquement isolante (3) au fur et à mesure que l'on s'éloigne de la couche électriquement isolante (3).

**8.** Procédé selon la revendication 7 **caractérisé en ce que** les électrodes (10) de source/drain sont du premier type de conductivité et sont obtenues lors de l'implantation ionique de la contre-électrode (8) de manière à obtenir une concentration en première impureté dopante décroissante depuis les électrodes (10) de source/drain vers la contre-électrode (8).

**9.** Procédé selon la revendication 8 **caractérisé en ce qu'**il comporte une étape d'implantation additionnelle de manière à former une zone de prise de contact (10b) de source/drain séparée du canal de conduction par une zone de dopage intermédiaire (10a), la zone de prise de contact (10b) étant plus dopée que la zone de dopage intermédiaire (10a).

**10.** Procédé selon la revendication 7 **caractérisé en ce que** les électrodes (10) de source/drain sont d'un second type de conductivité avec une seconde impureté dopante, les électrodes ayant une concentration en première impureté dopante décroissante depuis les électrodes (10) de source/drain vers la contre-électrode (8) et inférieure à la seconde impureté dopante.

Figure 1

Figure 2

Figure 3

Concentration (cm$^{-3}$)

z (µm)

4  3  2

Figure 4

Figure 5

Figure 6

Concentration
(cm$^{-3}$)

A

B

z (μm)

4    3       2

Figure 7

7

9    5    6    13

3b    3b    4

3    3

1    2a

11    8    3a    12    2

Figure 8

Figure 9

Figure 10

Europäisches
Patentamt

European
Patent Office

Office européen
des brevets

**RAPPORT DE RECHERCHE EUROPEENNE**

Numéro de la demande

EP 12 35 4004

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X<br>Y<br>A | US 2004/164305 A1 (KESHAVARZI ALI [US] ET AL) 26 août 2004 (2004-08-26)<br>* alinéa [0029] - alinéa [0041]; figure 4 * | 1,2,4<br>3,6<br>5,7-10 | INV.<br>H01L29/786<br>H01L21/265<br>H01L21/336<br>H01L29/66 |
| Y | ----- <br>US 2005/045947 A1 (CHEN HUAJIE [US] ET AL) 3 mars 2005 (2005-03-03)<br>* figures 1C,6B *<br>----- | 3,6 | |

DOMAINES TECHNIQUES
RECHERCHES (IPC)

H01L

Le présent rapport a été établi pour toutes les revendications

| Lieu de la recherche | Date d'achèvement de la recherche | Examinateur |
|---|---|---|
| Berlin | 21 mai 2012 | Juhl, Andreas |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
.....................................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 12 35 4004

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

21-05-2012

| Document brevet cité<br>au rapport de recherche | Date de<br>publication | Membre(s) de la<br>famille de brevet(s) | | Date de<br>publication |
|---|---|---|---|---|
| US 2004164305 A1 | 26-08-2004 | AU | 5927799 A | 26-04-2000 |
| | | DE | 69936899 T2 | 15-05-2008 |
| | | EP | 1135805 A1 | 26-09-2001 |
| | | TW | 486730 B | 11-05-2002 |
| | | US | 2002011622 A1 | 31-01-2002 |
| | | US | 2004164305 A1 | 26-08-2004 |
| | | WO | 0021137 A1 | 13-04-2000 |
| US 2005045947 A1 | 03-03-2005 | CN | 1591899 A | 09-03-2005 |
| | | US | 2005045947 A1 | 03-03-2005 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5889306 A